# EUROPÄISCHE PATENTANMELDUNG

(11) **EP 1 367 879 A2**
(43) Veröffentlichungstag der Anmeldung: **03.12.2003**
(21) Anmeldenummer: 03010051.5
(22) Anmeldetag: 02.05.2003
(51) Int. Cl.: H05K 9/00

(54) **Elektrische Vorrichtung**

(30) Priorität: 31.05.2002 DE 10224221
(71) Anmelder: SIEMENS AKTIENGESELLSCHAFT, 80333 München (DE)
(72) Erfinder: Berberich, Reinhold, 60439 Frankfurt (DE)

(57) **Zusammenfassung**

Gegenstand der Erfindung ist eine elektrische Vorrichtung mit einem elektrisch leitenden Abschirmungselement, welches auf ein elektronische Bauteile tragendes Trägersubstrat aufgesetzt ist, wobei das Trägersubstrat eine Leiterbahnstruktur zur elektrischen Verbindung der Bauteile einer elektronischen Baugruppe und der Baugruppe mit anderen Baugruppen aufweist und das Abschirmungselement zur Abschirmung elektromagnetischer Strahlung ausgebildet ist.

Um eine Vorrichtung anzugeben, welche eine einfach mechanisch zu fixierende und elektrisch zu kontaktierende elektromagnetische Abschirmung aufweist, ist auf dem Trägersubstrat mindestens eine, eine Schleife bildende elektrische Leiterbahn ausgebildet, die mindestens ein abzuschirmendes Bauteil auf dem Trägersubstrat umfasst und die eine Grenze zwischen dem elektromagnetisch ungeschirmten Bereich und dem geschirmten Bereich bildet und die mit einem festen elektrischen Potential verbunden ist und auf der Fläche der Leiterbahn und des darunter liegenden Trägersubstrats ist mindestens eine Ausnehmung ausgebildet, wobei mindestens eine an dem Abschirmungselement ausgebildete Rasteinrichtung in die mindestens eine Ausnehmung eingreift, wodurch das Abschirmungselement mit dem festen elektrischen Potential verbunden ist.

## Beschreibung

Die Erfindung betrifft eine elektrische Vorrichtung mit einem elektrisch leitenden Abschirmungselement, welches auf ein elektronische Bauteile tragendes Trägersubstrat aufgesetzt ist, wobei das Trägersubstrat eine Leiterbahnstruktur zur elektrischen Verbindung der Bauteile einer elektronischen Baugruppe und der Baugruppe mit anderen Baugruppen aufweist und das Abschirmungselement zur Abschirmung elektromagnetischer Strahlung ausgebildet ist.

Um eine einwandfreie Funktion von elektronischen Einrichtungen zu gewährleisten, ist es erforderlich diese gegenüber elektromagnetischer Störstrahlung, welche insbesondere im Hochfrequenzbereich auftritt, abzuschirmen. Solche Abschirmungen werden üblicherweise durch eine Umschließung der elektronischen Bauelemente oder Baugruppen mit einem elektrisch leitenden und gegen Masse kontaktierten Gehäuse erreicht.

Der Einschluss der elektrischen oder elektronischen Bauteile und Baugruppen in metallische Gehäuse ist aufwendig und teuer, da die Abschirmungselemente aufwendig mechanisch fixiert und elektrisch kontaktiert werden müssen, was zumeist durch verlöten oder verschweißen der Abschirmungselementen mit den metallischen Strukturen auf dem Substrat erfolgt.

Die DE 3520531 A1 legt eine elektromagnetische Abschirmung für Leiterplatten offen. Die Abschirmung der Leiterplatten erfolgt durch das Aufsetzten von kammerartigen Zusatzelementen aus Kunststoff auf die Leiterplatte. Die Zusatzelemente sind zur Abschirmung der elektromagnetischen Einflüsse auf ihrer Oberfläche metallisiert und mit gedruckten Leiterbahnen auf der Leiterplatte verbunden. Mittels durchkontaktierter Leiterbahnen wird eine Verbindung zu den auf der gegenüberliegenden Seite der Leiterplatte angeordneten, zur Abschirmung vorgesehenen, Zusatzelementen hergestellt.

Der vorliegenden Erfindung liegt somit die Aufgabe zugrunde, eine elektrische Vorrichtung anzugeben, welche eine einfach mechanisch zu fixierende und elektrisch zu kontaktierende elektromagnetische Abschirmung aufweist.

Erfindungsgemäß wird die Aufgabe dadurch gelöst, dass auf dem Trägersubstrat mindestens eine, eine Schleife bildende elektrische Leiterbahn ausgebildet ist, die mindestens ein abzuschirmendes Bauteil auf dem Trägersubstrat umfasst und die eine Grenze zwischen dem elektromagnetisch ungeschirmten Bereich und dem geschirmten Bereich bildet und die mit einem festen elektrischen Potential verbunden ist und dass auf der Fläche der Leiterbahn und des darunter liegenden Trägersubstrats mindestens eine Ausnehmung ausgebildet ist, wobei mindestens eine an dem Abschirmungselement ausgebildete Rasteinrichtung in die mindestens eine Ausnehmung eingreift, wodurch das Abschirmungselement mit dem festen elektrischen Potential verbunden ist.

Die Erfindung hat den Vorteil, dass durch die Rasteinrichtungen an dem Gehäuse und die Ausnehmungen auf dem Substrat eine schnelle, sichere und aufwandsarme elektrische Verbindung zwischen der in sich geschlossenen und auf das Substrat aufgebrachten Leiterbahn und dem Abschirmungselement ermöglicht wird. In nur einem Arbeitsgang wird sowohl die elektrische Kontaktierung des Abschirmungselements mit dem festen Potential erzeugt als auch die dauerhafte mechanische Verbindung des Abschirmungselements mit dem Substrat hergestellt.

In einer vorteilhaften Ausgestaltung sind die Rasteinrichtungen an dem Abschirmungselement als Einpresskontakte ausgebildet, die in die korrespondierenden Ausnehmungen auf dem Trägersubstrat eingepresst sind. Einpresskontakte lassen sich vor allem bei der Produktion großer Stückzahlen vorteilhaft zur schnellen und sicheren Verbindung des Abschirmungselements mit dem Substrat einsetzen.

Die an dem Abschirmungselement ausgebildeten Einpresskontakte müssen hierzu nur auf die korrespondierenden Ausnehmungen im Bereich der Leiterbahn auf dem Trägersubstrat aufgesetzt und mit einer vorbestimmten Kraft in die Ausnehmungen eingepresst werden. Beim Einschieben der Einpresskontakte bildet sich eine Kaltverschweißung zwischen den Kontakten und den zugeordneten Ausnehmungen, was einen sicheren mechanischen und elektrischen Kontakt bewirkt.

In einer Weiterbildung sind die Rasteinrichtungen an dem Abschirmungselement als biegbare Stifte ausgebildet, die durch die korrespondierenden lochförmigen Ausnehmungen auf dem Trägersubstrat durchgesteckt und dann abgebogen sind. Solche Stifte können mit sehr geringer Kraft durch die Ausnehmungen geführt werden und das Abbiegen der Stift ist ein sehr einfacher Arbeitsgang, der gut maschinell ausgeführt werden kann.

Alternativ dazu sind die Rasteinrichtungen an dem Abschirmungselement als biegbare, flache und zungenartige Streifen ausgebildet, die durch die korrespondierenden schlitzförmigen Ausnehmungen auf dem Trägersubstrat durchgesteckt und dann abgebogen sind. Streifenförmige Rasteinrichtungen haben den Vorteil, dass sie in der Biegerichtung leicht umzubiegen sind, während sie in allen anderen Richtungen sehr stabil sind. Streifenförmige Rasteinrichtungen lassen sich leicht aus einem Blechteil stanzen. Die flachen und zungenartigen Rasteinrichtungen können bei entsprechenden Erfordernissen auch in komplexen Formen ausgebildet sein, etwa in der eines Ankers oder in der eines in eine Ebene projizierten Tropfens.

Bei einer weiteren vorteilhaften Ausgestaltung ist das Trägersubstrat als Mehrlagenleiterplatte ausgebildet. Bei einer Mehrlagenleiterplatte werden Leiterbahnen in verschiedenen Ebenen geführt. Durch die zwischen den Ebenen angeordneten Isolatorlagen sind die Leiterbahnen in den verschiedenen Ebenen elektrisch voneinander getrennt, was die Realisierung verschiedener Stromkreise, mit unterschiedlichen Aufgaben in den verschiednen Ebenen ermöglicht. In einer inneren Leitebene der Mehrlagenleiterplatte werden die signalführenden Leiterbahnen vorteilhaft platziert und auf den äußern Leitebenen der Mehrlagenleiterplatte sind die masseführenden Leiterbahnen lokalisiert. Mehrlagenleiterplatten erlauben eine sehr flexible Gestaltung der Leiterbahnstrukturen.

Bei einer nächsten Ausgestaltung ist eine Filtereinrichtung in die Mehrlagenleiterplatte integriert, wobei die Filtereinrichtung als Kondensator ausgebildet ist, der aus einer ersten Leiterfläche, die über eine erste Leiterbahnstruktur mit einem festen ersten elektrischen Potential verbunden ist und einer zweiten, von der ersten elektrisch isolierten, Leiterfläche, die durch eine zweite Leiterbahnstruktur mit einem nicht notwendigerweise festen zweiten elektrischen Potential verbunden ist, gebildete ist, wobei die erste und zweite Leiterfläche annähernd gegenüberliegend angeordnet sind. Beim Betrieb eines elektrischen Geräts müssen aus dem ungeschirmten Bereich in den geschirmten Bereich und umgekehrt elektrische Signale über Leiterbahnen geführt werden. Diese Leiterbahnen können aber elektromagnetische Störsignale einfangen und weiterleiten. Durch die offengelegte vorteilhafte Ausgestaltung der Erfindung durchfließen die auf der Signalleiterbahn vorhandene hochfrequente Störsignale einen Kondensator, wobei sie gegen Masse abgeleitet werden, wodurch sie den abgeschirmten Bereich nicht erreichen. Leitungen die elektrischen Signale zwischen dem abgeschirmten und dem unabgeschirmten Bereich führen, werden durch die in der Mehrlagenleiterplatte integrierte Kondensatorstruktur nachhaltig entstört, was eine zuverlässige Signalverarbeitung im elektrischen Gerät gewährleistet.

Bei einer vorteilhaften Weiterbildung ist das Trägersubstrat zweiteilig ausgebildet, wobei ein erstes Teilsubstrat die abzuschirmenden Bauteile aufnimmt, die vollständig von dem Abschirmungselement umgeben sind und ein zweites Teilsubstrat alle ungeschirmten Bauteile aufnimmt, wobei das erste Teilsubstrat mit dem zweiten Teilsubstrat mittels elektrischer und mechanischer Verbindungselemente verbunden ist. Dies hat den Vorteil, dass nur die Bauteile mit einer elektromagnetischen Abschirmung versehen sind, bei denen diese Schutzmaßnahme notwendig ist. Durch die zweiteilige Ausbildung des Substrats können die Bauteile mit unterschiedlichen elektromagnetischen Schutzanforderungen leicht zusammengefasst werden und in einer Vorfertigung auf den jeweiligen Teilsubstraten platziert werde, bevor das vollständige Gerät durch das Verbinden der zwei Teilsubstrate entsteht.

Bei einer weiteren Ausgestaltung ist vorgesehen, dass das Verbindungselement zur elektrischen und mechanischen Verbindung beider Teilsubstrate an einer einzigen Seite des ersten Teilsubstrats steckerartig ausgebildet ist und an einer einzigen Seite des zweiten Teilsubstrats Mittel zu Aufnahme des steckerartigen Verbindungselements vorgesehen sind. Bei dieser Ausgestaltung können die zwei Teilsubstrate durch einfaches Verstecken zusammengefügt werden. Aufwendige Arbeitsgänge, wie das miteinander Verlöten oder Verschweißen der Verbindungselemente entfallen hierdurch.

In einer nächsten Ausgestaltung umfasst ein Gerätegehäuse das gesamte Substrat und die Abschirmelemente. Vorteilhaft ist, dass das Gerätegehäuse das gesamte Substrat mit den darauf befindlichen elektronischen Bauteilen vor Umgebungseinflüssen, wie Schmutz und Spritzwasser schützt. Es kann auch als zusätzlicher Schutz vor elektromagnetischen Einflüssen ausgebildet sein, sofern es aus einem elektrisch leitenden Material besteht.

Bei einer Weiterbildung ist das Gerätegehäuse aus Kunststoff gefertigt. Kunststoffgehäuse sind besonders kostengünstig herstellbar und beaufschlagen das Gesamtgerät nur mit einem geringen Eigengewicht.

Darüber hinaus ist es vorteilhaft, wenn elektromagnetisch besonders empfindliche Bauteile einzeln mit Abschirmelementen geschützt sind, welche über und unterhalb der Bauteile angeordnet sind. Bei einer beidseitigen Bestückung des Substrats mit elektronischen Bauteilen im elektromagnetisch abzuschirmenden Bereich ist es notwendig, erfindungsgemäße Abschirmelemente auf beiden Seiten des Substrats anzuordnen.

Bei einseitiger Bestückung des Substrats mit elektronischen Bauteilen ist es vorteilhaft, wenn elektromagnetisch besonders empfindliche Bauteile einzeln geschützt sind, wobei auf der Bestückungsseite des Substrats ein Abschirmelement vorgesehen ist und auf der anderen Seite das metallisierte Substrat die Abschirmungsfunktion erfüllt. Durch die Metallisierung der unbestückten Substratseite wird eine kostengünstige elektromagnetische Schirmung auf dieser Seite erreicht.

Die Erfindung lässt zahlreiche Ausführungsformen zu. Eine davon soll anhand der in den Zeichnungen dargestellten Figuren näher erläutert werden.

Es zeigt:
- Fig. 1:: einen Schnitt durch ein Kraftfahrzeugsteuergerät,
- Fig. 2:: eine bestückte und mit Ausnehmungen versehene Mehrlagenleiterplatte,
- Fig. 3:: das Abschirmelement und verschiedene Lagen der Mehrlagenleiterplatte,
- Fig. 4:: eine Mehrlagenleiterplatte mit einem elektromagnetisch ungeschirmten und einem abgeschirmten Bereich.

Gleiche Merkmale sind mit gleichen Bezugszeichen gekennzeichnet.

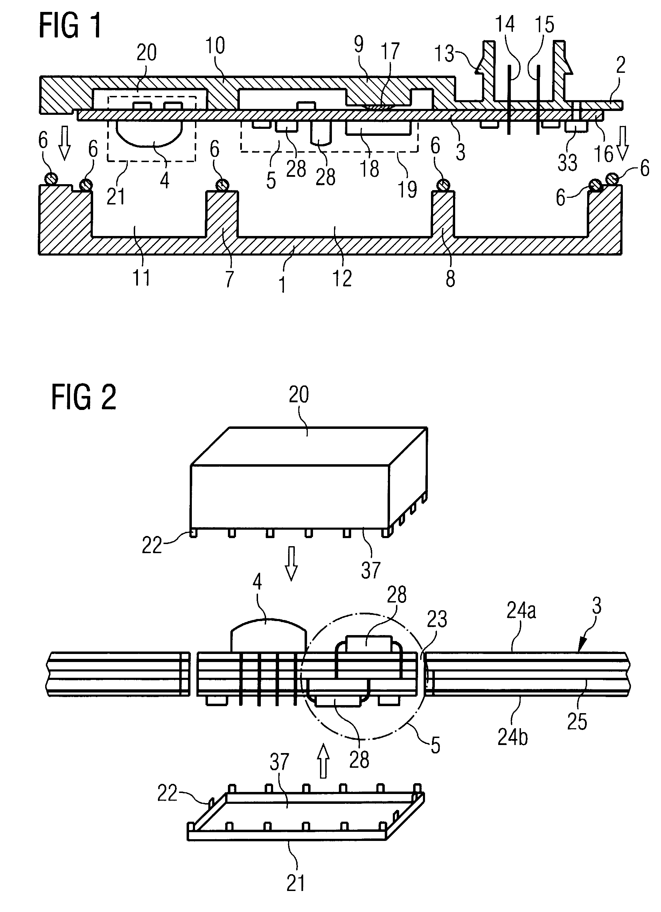

In Fig. 1 ist ein elektrisches Gerät dargestellt, wie es üblicherweise in Kraftfahrzeugen Anwendung findet. Dabei kann es sich um ein Steuergerät eines Kraftfahrzeuges handeln, welches eine signalverarbeitende Elektronik aufweist, die bekanntlicherweise sehr störanfällig gegenüber elektromagnetischer Strahlung mit hohen Frequenzen ist. Es ist aber auch vorstellbar, dass das elektrische Gerät eine Sensoreinrichtung darstellt, welche neben dem eigentlichen Sensor eine Signalaufbereitungsschaltung und/oder eine Signalauswerteschaltung aufweist, die auf einer oder mehreren Leiterplatten angeordnet sind.

Das elektrische Gerät besitzt ein becherförmiges Gerätegehäuse 1, welches mit einer Gerätegehäuseabdeckung 2 verschlossen ist. Das Gerätegehäuse 1 schützt die Signalaufbereitungselektronik 5 mit den elektronischen Bauteilen 18, 28 und dem Sensor 4 in erster Linie vor mechanischen Einflüssen und vor Schäden durch Spritzwasser. Innerhalb des Gerätegehäuses 1 ist eine Mehrlagenleiterplatte 3 angeordnet, die den Sensor 4 und die Signalaufbereitungselektronik 5 für den Sensor 4 trägt. Der Sensor 4 und die Signalaufbereitungselektronik 5 sind sehr empfindlich gegenüber störender elektromagnetischer Strahlung und müssen durch geeignete Abschirmungselemente 19, 20, 21 vor dieser geschützt werden. Die elektrisch leitenden Abschirmungselemente 19, 20, 21 zum Schutz empfindlicher, elektronischer Bauteile 18, 28 oder Baugruppen sind in dieser Zeichnung durch die gestrichelten Linien angedeutet.

Die Gerätegehäuseteile 1, 2 sind mittels einer Leitgummidichtung 6 gegeneinander abgedichtet. Das Gerätegehäuse 1 weist zwei, in das Gehäuseinnere ragende Stege 7, 8 auf. Auf diese Weise sind zwei Kammern 11, 12 gebildet, wobei der Sensor 4 in einer Kammer 11 und die Signalaufbereitungselektronik 5 in einer weiteren Kammer 12 lokalisiert ist. Ein Sockel 10 stützt die Mehrlagenleiterplatte 3 mechanisch ab.

Ein Steg in der Gerätegehäuseabdeckung 2 dient als Kühldom 9, welcher über einen Wärmeleitkleber 17 mit der Leiterplatte 3 thermisch kontaktiert ist. Auf der dem Kühldom 9 entgegengesetzten Seite der Leiterplatte 3 ist ein Leistungsbauelement 18 der Signalaufbereitungselektronik 5 angeordnet. Die von diesem Leistungsbauelement 18 abgegebene Verlustleistung wird über den Kühldom 9 an die Umgebung abgeführt.

An der Gerätegehäuseabdeckung 2 ist außerdem ein Stecker 13 angeordnet, dessen Steckerpins 14, 15 durch die Gerätegehäuseabdeckung 2 hindurchgreifen und in einem Endbereich 16 der Leiterplatte 3 kontaktiert sind. Die Steckerpins 14, 15 verbinden über die Leitebenen der Mehrlagenleiterplatte 3 die Signalaufbereitungselektronik 5 bzw. den Sensor 4 mit elektronischen Einrichtungen im Kraftfahrzeug. Sie dienen zur Zuführung von Signalen und elektrischer Leistung für die im Inneren des Gehäuses befindlichen Baugruppen 4, 5.

Fig. 2 zeigt eine bestückte und mit Ausnehmungen 23 versehene Mehrlagenleiterplatte 3 mit den beiden metallischen Abschirmungselementen 20, 21. Die Mehrlagenleiterplatte 3 umfasst eine signalführende Lage 25, über deren Leiterbahnen die vom Sensor 4 gemessenen Signale zur Signalaufbereitungselektronik 5 geführt werden. Über die signalführende Lage 25 werden auch die Versorgungsspannungen zu den Bauelementen geführt und die in der Signalaufbereitungselektronik 5 verarbeiteten Signale zur weiteren Verwendung weitergeleitet. Die mit Masse belegten Leiterbahnen sind auf den masseführenden Lagen 24a, 24b der Mehrlagenleiterplatte 3 angeordnet. Sie stellen ein festes elektrisches Bezugspotential bereit, das idealer Weise über die gesamte Masseleiterbahn völlig konstant ist. Das obere Abschirmungselemente 20 wird mit der masseführenden Leiterbahnen auf der oberen masseführenden Lage 24a der Mehrlagenleiterplatte 3 verbunden und das untere Abschirmungselement 21 wird in analoger Weise mit der masseführenden Leiterbahn auf der unteren masseführenden Lage 24b der Mehrlagenleiterplatte 3 verbunden. Dabei setzen die Ränder 37 der Abschirmungselemente 20, 21 vollständig auf den masseführenden Leiterbahnen der jeweiligen masseführenden Lagen 24a, 24b auf, wodurch ein elektrischer Kontakt zwischen den Rändern 37 der Abschirmungselemente 20, 21 und den masseführenden Leiterbahnen entsteht.

Zur einfachen Verbindung der metallischen Abschirmungselemente 20, 21 mit der Mehrlagenleiterplatte 3 sind an den Abschirmungselementen 20, 21 Rasteinrichtungen 22 ausgebildet, zu denen auf der Mehrlagenleiterplatte 3 korrespondierende Ausnehmungen 23 vorhanden sind. Diese Ausnehmungen 23 können als Bohrungen mit dem notwendigen Durchmesser und einer geeigneten Tiefe aber auch als Langlöcher oder Schlitze ausgebildet sein. Im speziellen Anwendungsfall können sowohl Sackbohrungen als auch Durchgangsbohrungen vorteilhaft eingesetzt werden. Auch die Rasteinrichtungen 22 an den Abschirmungselementen 20, 21 stehen über an den Innenwandungen metallisierte Ausnehmungen 23 im elektrischen Kontakt mit den auf der Mehrlagenleiterplatte 3 ausgebildeten masseführenden Leiterbahnen. Die Rasteinrichtungen 22 erfüllen somit gleichzeitig die Aufgabe der mechanischen Anbindung der Abschirmungselemente 20, 21 an die Mehrlagenleiterplatte 3 und der elektrischen Kontaktierung der Abschirmungselemente 20, 21 mit den masseführenden Leiterbahnen.

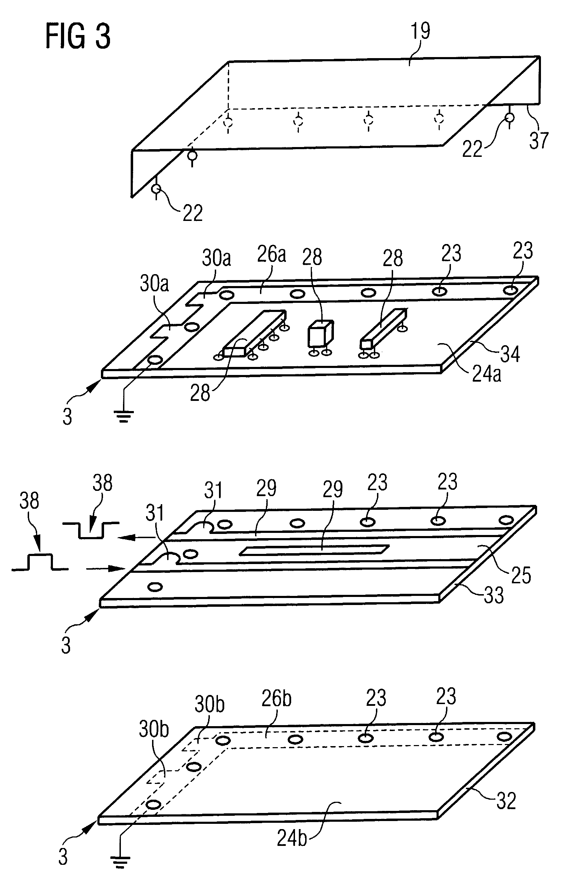

In Fig. 3 sind die masseführenden Lagen 24a, 24b und eine signalführende Lage 25 einer Mehrlagenleiterplatte 3 dargestellt. Die Lagen 24a, 24b, 25 bestehen aus glasgewebeverstärkten Kunstharzschichten 32, 33, 34, auf die elektrische Leiterbahnen 26a, 26b, 29 aufgebracht sind und die zur Mehrlagenleiterplatte 3 zusammengefügt werden. Auf der oberen masseführenden Lage 24 sind elektronische Bauteile 28 angedeutet. Die elektronischen Bauteile 28 sind durch die obere Lage 24a hindurch mit den Leiterbahnen 29 auf der signalführenden Lage 25 elektrisch kontaktiert. Über die Leiterbahnen 29 werden auf der signalführenden Lage 25 der Mehrlagenleiterplatte 3 Messsignale 38 transportiert und die Bauelemente 28 werden mit elektrischem Strom versorgt. An den Leiterbahnen 26a, 26 b, 29 sind kapazitive Leiterflächen 30a, 30b, 31 ausgebildet. Die Leiterflächen 31 auf der signalführenden Lage 25 liegen in Deckung mit den Leiterflächen 30a, 30b auf den masseführenden Lagen 24a, 24b, womit eine Kondensatorstruktur hergestellt ist. Die Kapazität des gebildeten Kondensators kann durch die Wahl der Größe und des Abstandes der sich deckenden Leiterflächen 30a, 30b, 31 festgelegt werden. Dieser Kondensator filtert hochfrequente Störsignale, die über die Leiterbahnen 29 in die Richtung des abgeschirmten Bereichs vordringen heraus.

Darüber hinaus schützt ein metallisches Abschirmungselement 19 die empfindlichen elektronischen Bauteile 28 vor eingestrahlten elektromagnetischen Einflüssen, die nicht auf den Leiterbahnen 29 transportiert werden. Das Abschirmungselement 19 ist mittels Rasteinrichtungen 22, die zum Beispiel als Einpresskontakte ausgebildet sein können und die in die Ausnehmungen 23 eingepresst werden, mit der Mehrlagenleiterplatte 3 verbunden. Eine elektrische Kontaktierung des metallischen Abschirmungselements 19 mit den masseführenden Leiterbahnen 26 erfolgt durch Auflage des Randes 37 des Abschirmungselements 19 auf die obere masseführende Leiterbahn 26 und / oder durch die Kontaktierung der Rasteinrichtungen 22 mit zu den masseführenden Leiterbahnen 26 elektrisch durchkontaktierten Ausnehmungen 23.

Die Lage der Rasteinrichtungen 22 im Bezug auf die Leiterbahnen 29 und die masseführende Leiterbahn 26 wird so gewählt, dass beim Einsetzen der Rasteinrichtungen 22 in die Ausnehmungen 23 ein elektrischer Kontakt zwischen dem metallischen Abschirmungselement 19 und dem Massepotential sicher hergestellt wird aber keinesfalls eine elektrisch leitende Verbindung des Abschirmungselements 19 zu einer ein Signal oder eine Versorgungsspannung führenden Leiterbahn 29 entsteht.

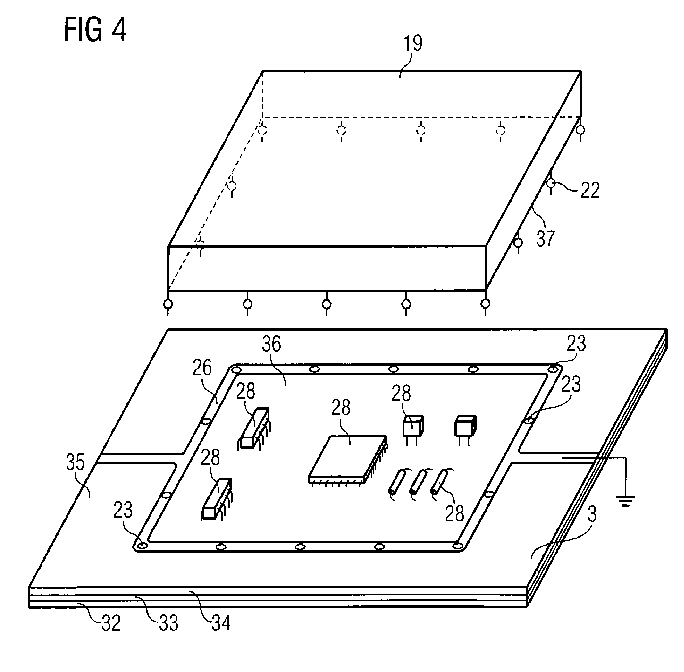

Fig. 4 zeigt eine Mehrlagenleiterplatte 3 mit einem elektromagnetisch ungeschirmten 35 und einem geschirmten Bereich 36. Der abgeschirmte Bereich 36 auf der Mehrlagenleiterplatte 3, die aus einer Folge von glasgewebeverstärkten Kunstharzschichten 32, 33, 34 gebildet ist, wird durch eine in sich geschlossene masseführende Leiterbahn 26 vom elektromagnetisch ungeschirmten Bereich 35 abgegrenzt. Innerhalb des abgeschirmten Bereichs 36 sind alle gegen störende elektromagnetische Einflüsse empfindlichen elektronischen Bauteile 28 angeordnet. Die elektromagnetische Abdichtung des Raumes über dem abgeschirmten Bereich 36 auf der Mehrlagenleiterplatte 3 erfolgt durch das Aufsetzten des metallischen Abschirmungselements 19. Hierzu werden die Rasteinrichtungen 22, die zum Beispiel als Einpresskontakte ausgebildet sein können, erfindungsgemäß in die Ausnehmungen 23, die auf der metallisierten Fläche der masseführenden Leiterbahn 26 in die Mehrlagenleiterplatte 3 eingebracht sind, eingeführt und durch Verpressen fest in den Ausnehmungen 23 verankert. Beim Pressen der Rasteinrichtungen 22 in die korrespondierenden Ausnehmungen 23 entsteht zwischen den metallisierten Schichten in den Ausnehmungen 23 und den Rasteinrichtungen 22 eine Kaltverschweißung die eine sichere mechanische und elektrische Verbindung gewährleistet. Der Rand 37 des Abschirmungselements 19 setzt beim Zusammenfügen von Abschirmungselement 19 und Mehrlagenleiterplatte 3 vollständig auf der in sich geschlossenen masseführende Leiterbahn 26 auf. Hierdurch entsteht ein vollständig elektromagnetisch abgeschirmter Raum, in dem die empfindlichen elektronischen Bauteile 28 lokalisiert sind. Durch die erfindungsgemäßen Rastelemente 22 am Abschirmelement 19 in Verbindung mit den korrespondierenden Ausnehmungen 23 im metallisierten Bereiche der masseführenden Leiterbahn 26 auf der Mehrlagenleiterplatte 3 wird, eine elektrische und mechanische Verbindung der Mehrlagenleiterplatte 3 mit dem Abschirmungselement 19 in nur einem einzigen Arbeitsgang möglich.

## Patentansprüche

1. Elektrische Vorrichtung mit einem elektrisch leitenden Abschirmungselement, welches auf ein elektronische Bauteile tragendes Trägersubstrat aufgesetzt ist, wobei das Trägersubstrat eine Leiterbahnstruktur zur elektrischen Verbindung der Bauteile einer elektronischen Baugruppe und der Baugruppe mit anderen Baugruppen aufweist und das Abschirmungselement zur Abschirmung elektromagnetischer Strahlung ausgebildet ist, **dadurch gekennzeichnet, dass** auf dem Trägersubstrat mindestens eine, eine Schleife bildende elektrische Leiterbahn (26) ausgebildet ist, die mindestens ein abzuschirmendes Bauteil (4, 18, 28) auf dem Trägersubstrat umfasst und die eine Grenze zwischen dem elektromagnetisch ungeschirmten Bereich (35) und dem geschirmten Bereich (36) bildet und die mit einem festen elektrischen Potential verbunden ist und dass auf der Fläche der Leiterbahn (26) und des darunter liegenden Trägersubstrats mindestens eine Ausnehmung (23) ausgebildet ist, wobei mindestens eine an dem Abschirmungselement (19, 20, 21) ausgebildete Rasteinrichtung (22) in die mindestens eine Ausnehmung (23) eingreift, wodurch das Abschirmungselement (19, 20, 21) mit dem festen elektrischen Potential verbunden ist.

2. Elektronische Vorrichtung nach Anspruch 1 **dadurch gekennzeichnet, dass** die Rasteinrichtungen (22) an dem Abschirmungselement (19, 20, 21) als Einpresskontakte ausgebildet sind, die in die korrespondierenden Ausnehmungen (23) auf dem Trägersubstrat eingepresst sind.

3. Elektronische Vorrichtung nach Anspruch 1 **dadurch gekennzeichnet, dass** die Rasteinrichtungen an dem Abschirmungselement (19, 20, 21) als biegbare Stifte ausgebildet sind, die durch die korrespondierenden lochförmigen Ausnehmungen (23) auf dem Trägersubstrat durchgesteckt und dann abgebogen sind.

4. Elektronische Vorrichtung nach Anspruch 3 **dadurch gekennzeichnet, dass** die Rasteinrichtungen an dem Abschirmungselement (19, 20, 21) als biegbare, flache und zungenartige Streifen ausgebildet sind, die durch die korrespondierenden schlitzförmigen Ausnehmungen (23) auf dem Trägersubstrat durchgesteckt und dann abgebogen sind.

5. Elektronische Vorrichtung nach Anspruch 1 **dadurch gekennzeichnet, dass** das Trägersubstrat als Mehrlagenleiterplatte (3) ausgebildet ist.

6. Elektronische Vorrichtung nach Anspruch 5 **dadurch gekennzeichnet, dass** eine Filtereinrichtung in die Mehrlagenleiterplatte (3) integriert ist, wobei die Filtereinrichtung als Kondensator ausgebildet ist, der aus einer ersten Leiterfläche (30), die über eine erste Leiterbahnstruktur (26a, 26b) mit einem festen ersten elektrischen Potential verbunden ist und einer zweiten, von der ersten elektrisch isolierten, Leiterfläche (31), die durch eine zweite Leiterbahnstruktur (29) mit einem nicht notwendigerweise festen zweiten elektrischen Potential verbunden ist, gebildete ist, wobei die erste (30) und zweite Leiterfläche (31) annähernd gegenüberliegend angeordnet sind.

7. Elektronische Vorrichtung nach Anspruch 1 und/oder 5 **dadurch gekennzeichnet, dass** das Trägersubstrat zweiteilig ausgebildet ist, wobei ein erstes Teilsubstrat die abzuschirmenden Bauteile aufnimmt, die vollständig von dem Abschirmungselement (19, 20, 21) umgeben sind und ein zweites Teilsubstrat alle ungeschirmten Bauteile aufnimmt, wobei das erste Teilsubstrat mit dem zweiten Teilsubstrat mittels elektrischer und mechanischer Verbindungselemente verbunden ist.

8. Elektronische Vorrichtung nach Anspruch 7 **dadurch gekennzeichnet, dass** das Verbindungselement zur elektrischen und mechanischen Verbindung beider Teilsubstrate an einer einzigen Seite des ersten Teilsubstrats steckerartig ausgebildet ist und an einer einzigen Seite des zweiten Teilsubstrats Mittel zu Aufnahme des steckerartigen Verbindungselements vorgesehen sind.

9. Elektronische Vorrichtung nach mindestens einem der vorgenannten Ansprüche **dadurch gekennzeichnet, dass** ein Gerätegehäuse (1) das gesamte Substrat und die Abschirmungselemente (19, 20,21) umfasst.

10. Elektronische Vorrichtung nach Anspruch 9 **dadurch gekennzeichnet, dass** das Gerätegehäuse (1) aus Kunststoff gefertigt ist.

11. Elektronische Vorrichtung nach mindestens einem der vorgenannten Ansprüche **dadurch gekennzeichnet, dass** elektromagnetisch besonders empfindliche Bauteile (4) einzeln mit Abschirmungselementen (20, 21) geschützt sind, welche über und unterhalb der Bauteile angeordnet sind.

12. Elektronische Vorrichtung nach mindestens einem der vorgenannten Ansprüche **dadurch gekennzeichnet, dass** elektromagnetisch besonders empfindliche Bauteile (4) einzeln geschützt sind, wobei auf der Bestückungsseite des Substrats ein Abschirmungselement (19) vorgesehen ist und auf der anderen Seite das metallisierte Substrat die Abschirmungsfunktion erfüllt.
